# FASCICULE DE BREVET EUROPEEN

(11) **EP 0 813 068 B1**
(45) Date de publication et mention de la délivrance du brevet: **02.08.2000**
(21) Numéro de dépôt: 97401287.4
(22) Date de dépôt: 09.06.1997
(51) Int. Cl.: G01R 31/00, G01R 29/08

(54) **Dispositif pour détecter et localiser des anomalies de la protection électromagnétique d'un système**
Anordnung zur Aufspürung und Lokalisierung von Fehlern in der elektromagnetischen Abschirmung eines Systems
Detecting and localising appliance for flaws in the electromagnetic protection of a system

(30) Priorité: 13.06.1996 FR 9607338
(43) Date de publication de la demande: 17.12.1997
(73) Titulaire: EUROCOPTER, F-13725 Marignane Cédex (FR)
(72) Inventeur: Ponçon, Marc Robert, 13009 Marseille (FR)
(74) Mandataire: Bonnetat, Christian

(56) Documents cités:
- EP-A- 0 248 501
- US-A- 5 153 524

## Description

La présente invention concerne un dispositif pour détecter et localiser d'éventuelles anomalies de la protection électromagnétique d'un système comportant des corps électriques et des éléments protecteurs de ces corps électriques, formant ladite protection électromagnétique.

Bien que non exclusivement, la présente invention est plus particulièrement appropriée à un système correspondant au moins à une partie d'un aéronef, tel qu'un hélicoptère.

On sait qu'en raison notamment de l'utilisation croissante sur les aéronefs de matériaux faiblement conducteurs ou non conducteurs électriquement, et de l'augmentation du nombre de corps électriques, par exemple des câbles ou des composants électriques, sensibles à l'environnement électromagnétique, les constructeurs d'aéronefs prévoient de plus en plus sur les aéronefs des éléments protecteurs destinés à protéger lesdits corps électriques sensibles.

Ces éléments protecteurs sont réalisés en particulier sous forme :
- de blindages de câbles électriques, créant une protection directe ; ou
- de moyens, par exemple des joints à hautes fréquences, créant des faradisations locales dans le système.

De tels éléments protecteurs présentent bien entendu une usure due notamment aux contraintes mécaniques et/ou climatiques auxquelles ils sont soumis. De façon connue, ladite usure est généralement d'autant plus importante que lesdits éléments protecteurs sont performants.

De plus, ces éléments protecteurs peuvent être endommagés par des perturbations de l'environnement électromagnétique, telles que la foudre par exemple.

Cette usure et ces éventuels endommagements nécessitent des opérations de maintenance pour maintenir le niveau de protection (électromagnétique) minimale requis pour ledit système.

Les opérations de maintenance réalisées actuellement consistent généralement en un remplacement périodique de tous les éléments protecteurs du système, la période de remplacement prescrite étant choisie de sorte que l'usure maximale supposée durant cette période ne puisse pas compromettre l'efficacité de la protection électromagnétique.

De telles opérations de maintenance ou remplacements d'éléments protecteurs, qui ne tiennent donc pas compte de l'état d'usure réel desdits éléments protecteurs, présentent un double inconvénient :
- d'une part, tous les éléments protecteurs sont remplacés après la durée d'utilisation prescrite correspondante, même s'ils sont encore en bon état, ce qui entraîne souvent des remplacements inutiles et présente donc un coût extrêmement élevé ; et
- d'autre part, des éléments protecteurs devenus subitement défectueux, par exemple suite à une contrainte anormale ou à un accident, ne sont pas remplacés avant le terme prescrit, ce qui risque d'entraîner des effets extrêmement dommageables.

Par ailleurs, on connaît différents dispositifs pour détecter des anomalies de la protection électromagnétique d'une enceinte. En particulier :
- le document US-5 153 524 décrit un dispositif qui comporte des émetteurs de fréquences radio, agencés par paires aux coins externes opposés de l'enceinte, et un détecteur de fréquences radio situé à l'intérieur de ladite enceinte. Ledit détecteur mesure la somme de l'énergie captée lors d'émissions de fréquences radio réalisées respectivement par chacune desdites paires d'émetteurs, fait la moyenne pour toutes les paires d'émetteurs des valeurs ainsi mesurées et compare cette moyenne à une valeur de référence, pour en déduire une éventuelle anomalie de la protection électromagnétique ; et
- le document EP-0 248 501 décrit un dispositif qui comporte des moyens de génération et des moyens de détection d'un champ magnétique ou électrique, disposés respectivement des deux côtés de la protection électromagnétique de l'enceinte, ainsi qu'une unité de traitement d'informations. Ce dernier dispositif est particulièrement approprié au contrôle d'une enceinte de volume important.

Par conséquent, ces dispositifs connus sont exclusivement destinés au contrôle d'une enceinte unique, de réalisation homogène. Ils ne peuvent pas être utilisés pour contrôler un système comportant une pluralité de corps électriques différents et ne peuvent donc pas servir d'aide à la maintenance pour un tel système.

La présente invention a pour objet de remédier à ces inconvénients. Elle concerne un dispositif, de coût réduit, permettant de détecter et localiser, de façon rapide et sans contact, d'éventuelles anomalies de la protection électromagnétique d'un système, par exemple au moins une partie d'un aéronef, comportant :
- des corps électriques ; et
- des éléments protecteurs de ces corps électriques, formant ladite protection électromagnétique.

A cet effet, selon l'invention, ledit dispositif comprenant au moins un émetteur et un récepteur d'ondes électromagnétiques, ainsi qu'une unité de traitement d'informations, est remarquable en ce que :
- ledit émetteur comporte une antenne susceptible d'émettre une onde électromagnétique à l'extérieur dudit système ;
- ledit récepteur comprend un ensemble de capteurs susceptibles de mesurer une grandeur représentative d'une onde électromagnétique captée, associés à au moins certains desdits éléments protecteurs et agencés de façon à être protégés par lesdits éléments protecteurs ; et
- ladite unité de traitement d'informations est une unité centrale :
   . recevant les valeurs de la grandeur mesurée par lesdits capteurs, lors de l'émission d'une onde électromagnétique par ledit émetteur,
   . comparant ces valeurs à une valeur de référence enregistrée et mesurée dans une étape préliminaire lors de l'émission d'une onde électromagnétique identique dans un état de référence de la protection électromagnétique,
   . détectant, à partir de ces comparaisons, d'éventuelles anomalies de la protection électromagnétique, et
   . localisant, le cas échéant, une anomalie en fonction de la position des capteurs, dont les valeurs mesurées sont incriminées.

L'analyse experte de l'ensemble des données permet ainsi de discriminer au mieux les dérives incriminées : protection globale, locale ou variations liées à l'émetteur.

Selon que ces dérives concernent un ou plusieurs capteurs, on peut en déduire qu'il s'agit de la faiblesse d'une protection unique, de l'ensemble, d'une zone ou d'une dérive des caractéristiques de l'émission.

Ainsi, comme selon l'invention, on détermine les anomalies de la protection électromagnétique, à partir du contrôle de l'état d'usure réel des éléments protecteurs, on peut mettre en oeuvre des opérations de maintenance appropriées à cet état d'usure réel, ce qui permet :
- de réduire le coût de maintenance, puisque la maintenance n'est réalisée que pour les éléments protecteurs réellement défectueux ; et
- d'augmenter la sécurité, puisque tous les éléments défectueux sont remplacés, à la différence des méthodes de maintenance connues et précitées de l'état de la technique.

De plus, grâce à l'invention, on est en mesure de localiser directement et précisément tout élément protecteur défectueux.

En outre, ledit dispositif conforme à l'invention présente d'autres avantages, notamment :
- le contrôle peut être réalisé rapidement et simplement, donc on peut le mettre en oeuvre aussi fréquemment et aussi souvent que souhaité ou nécessaire. Cet avantage, ainsi que la précision obtenue, sont dus notamment aux caractéristiques de l'unité de traitement d'informations, qui est réalisée sous forme d'une unité centralisant les traitements et qui effectue des comparaisons directement à partir des valeurs mesurées, et non en effectuant au préalable une moyenne des valeurs mesurées, comme cela est le cas pour le dispositif décrit dans le document US-5 153 524 précité ; et
- le contrôle est réalisé sans contact physique, ce qui élimine tout risque d'endommagement des éléments protecteurs lors dudit contrôle.

La présente invention est particulièrement bien appropriée à un système qui comporte un émetteur d'ondes électromagnétique, comme par exemple un aéronef qui comporte un dispositif émetteur/récepteur de radiocommunication, puisque dans ce cas, on peut utiliser ledit émetteur du système pour la mise en oeuvre de l'invention, ce qui entraîne notamment une réduction du coût. Ledit émetteur peut être, soit un émetteur à modulation d'amplitude, soit un émetteur à modulation de fréquence, en raison de l'absence de modulation, comme on le verra ci-dessous.

De plus, de façon avantageuse, le dispositif conforme à l'invention comporte :
- une alarme qui est déclenchée lorsqu'une anomalie est détectée ; et/ou
- une unité de stockage enregistrant les mesures réalisées par lesdits capteurs, notamment en vue d'une exploitation ultérieure, de préférence sur un support autonome, tel qu'une disquette, une bande magnétique ou une cartouche de mémoire, pouvant être séparé dudit dispositif.

Par ailleurs, selon l'invention, ledit état de référence de la protection électromagnétique correspond à l'état pour lequel ladite protection est conforme à ses spécifications. Ceci peut être l'état neuf de ladite protection électromagnétique ou l'état résultant d'une opération de maintenance.

En outre, dans un mode de réalisation particulièrement avantageux de l'invention, lesdits capteurs qui sont reliés, électriquement ou par l'intermédiaire de fibres optiques, à ladite unité centrale, sont susceptibles d'être mis dans un état de veille constant, dans lequel ils captent et transmettent à l'unité centrale toutes les valeurs mesurées, qui sont supérieures à une valeur prédéterminée, et/ou pour lesquelles les ondes électromagnétiques correspondantes présentent des durées d'émission supérieures à une durée prédéterminée. Ce mode de réalisation permet de savoir, selon que l'on est en présence d'une détection multiple ou d'une détection unique, si les ondes électromagnétiques captées sont dues à une défaillance de la protection électromagnétique ou à une exposition dudit système à un environnement extrêmement sévère.

De plus, selon l'invention, la grandeur mesurée par lesdits capteurs est, soit une grandeur électrique, soit une grandeur radioélectrique.

Par ailleurs, ladite unité centrale peut comporter avantageusement des moyens pour modifier ladite valeur de référence enregistrée.

Les figures du dessin annexé feront bien comprendre comment l'invention peut être réalisée. Sur ces figures, des références identiques désignent des éléments semblables.

La figure 1 est le schéma synoptique d'un dispositif conforme à l'invention.

La figure 2 est le schéma synoptique d'une unité centrale du dispositif de la figure 1.

La figure 3 est le schéma synoptique d'une unité d'acquisition de l'unité centrale de la figure 2.

La figure 4 est le schéma synoptique d'une unité de traitement de données de l'unité centrale de la figure 2.

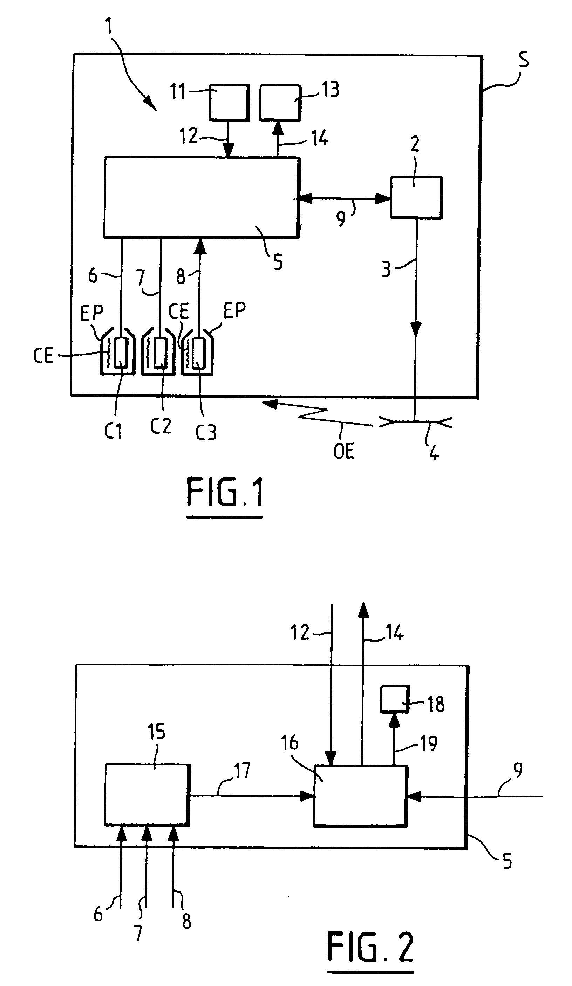

Le dispositif 1 conforme à l'invention et représenté schématiquement sur la figure 1 est destiné à détecter et à localiser d'éventuelles anomalies de la protection électromagnétique d'un système S représenté partiellement et comportant :
- des corps électriques CE ; et
- des éléments protecteurs EP de ces corps électriques CE, formant ladite protection électromagnétique.

Dans le cadre de la présente invention, ledit système S peut correspondre à tout système présentant une telle protection électromagnétique, et notamment à au moins une partie d'un aéronef, tel qu'un hélicoptère.

Sur un aéronef, lesdits éléments protecteurs EP représentent par exemple :
- des blindages de câbles électriques ; ou
- des moyens, comme par exemple des joints à hautes fréquences, créant des faradisations locales.

Le dispositif 1 conforme à l'invention est destiné à déterminer l'état d'usure réel des éléments protecteurs EP de manière à pouvoir réaliser si nécessaire une opération de maintenance correspondant généralement à un remplacement des éléments défectueux, qui est appropriée à cet état réel d'usure, à la différence des opérations de maintenance connues qui réalisent le remplacement de façon périodique, quelle que soit l'usure des éléments remplacés.

A cet effet, selon l'invention, ledit dispositif 1 comporte, tel que représenté sur la figure 1 :
- au moins un émetteur 2 d'ondes électromagnétiques OE comportant une antenne 4 reliée à l'émetteur 2 par une liaison 3, agencée à l'extérieur du système S, par exemple sur la structure d'un aéronef lorsque le système S représente un aéronef, et susceptible d'émettre des ondes électromagnétiques OE ;
- un ensemble de capteurs C1, C2, C3 susceptibles de mesurer une grandeur électrique ou radioélectrique, représentative d'une onde électromagnétique OE captée, associés respectivement aux éléments protecteurs EP et agencés de façon à être protégés par lesdits éléments protecteurs EP, tel que représenté schématiquement sur la figure 1. Lesdits capteurs C1 à C3 peuvent être passifs ou actifs. Ils peuvent être réalisés sous forme de capteurs de champ électrique ou de champ magnétique, ou sous forme de sondes de mesure de courant ou de tension. La bande passante de ces capteurs C1 à C3 est adaptée à la bande de fréquences de fonctionnement de l'émetteur 2 ; et
- une unité centrale 5 reliée auxdits capteurs C1 à C3, respectivement par l'intermédiaire de liaisons 6, 7 et 8, par exemple des fils électriques ou des fibres optiques, ainsi qu'audit émetteur 2 par l'intermédiaire d'une liaison 9, ladite unité centrale 5 :
   . recevant les valeurs de la grandeur mesurée par lesdits capteurs C1 à C3, lors de l'émission d'une onde électromagnétique OE par ledit émetteur 2,
   . comparant ces valeurs à une valeur de référence enregistrée et mesurée dans une phase préliminaire lors de l'émission d'une onde électromagnétique identique dans un état de référence de la protection électromagnétique, ledit état de référence correspondant soit à l'état neuf de la protection électromagnétique, soit à l'état résultant d'une opération de maintenance, c'est-à-dire à un état pour lequel ladite protection est conforme à ses spécifications,
   . détectant, à partir de ces comparaisons, d'éventuelles anomalies de la protection électromagnétique, et
   . localisant, le cas échéant, une anomalie en fonction de la position du capteur C1, C2 ou C3, dont la valeur mesurée est incriminée.

Ainsi, grâce à l'invention, on vérifie l'état d'usure réel des éléments protecteurs EP, ce qui permet, lors des opérations de maintenance, de remplacer tous les éléments protecteurs réellement défectueux et uniquement ces derniers.

En outre, la vérification de l'état d'usure réel peut être réalisée fréquemment, puisque sa mise en oeuvre est rapide et facile.

De plus, cette vérification est réalisée sans entrer en contact avec les éléments protecteurs contrôlés, ce qui évite d'endommager lesdits éléments protecteurs lors dudit contrôle.

La présente invention est particulièrement bien appropriée à un système comportant un émetteur 2 d'ondes électromagnétiques, puisque dans ce cas, il suffit de prévoir par exemple les capteurs C1 à C3 et l'unité centrale 5 pour la mise en oeuvre de l'invention, ce qui permet notamment de réduire le coût du dispositif 1.

A cet effet, l'émetteur 2 peut être un dispositif émetteur/ récepteur de radiocommunication, du type standard, de préférence à commande centralisée, bien que l'on utilisera uniquement la fonction d'émission lors de la mise en oeuvre de la présente invention.

Comme on le verra ci-dessous, ledit émetteur 2 peut être un émetteur à modulation d'amplitude ou un émetteur à modulation de fréquence, puisqu'aucune modulation n'est à réaliser lors du contrôle.

Le dispositif 1 conforme à l'invention comporte, de plus :
- un moyen de commande 11 relié par une liaison 12 à l'unité centrale 5 pour déclencher la mise en oeuvre de l'invention ; et
- une alarme 13 qui est reliée par l'intermédiaire d'une liaison 14 à l'unité centrale 5 et qui est déclenchée lorsqu'une anomalie est détectée par ladite unité centrale 5, de manière à pouvoir réaliser, par exemple immédiatement, les opérations de maintenance nécessaires. Dans le cas d'un aéronef, cette alarme 13, ainsi que le moyen de commande 11, peuvent par exemple être installés dans la cabine de pilotage.

En outre, dans un mode de réalisation particulier non représenté, ledit moyen de commande 11 et ladite alarme 13 peuvent de plus être agencés sur un support commun.

Comme on peut le voir sur la figure 2, ladite unité centrale 5 comporte :
- une unité d'acquisition 15, précisée ci-dessous ;
- une unité de traitement 16 également précisée ci-dessous et reliée par une liaison 17 à ladite unité d'acquisition 15 ; et
- une unité de stockage 18 reliée par une liaison 19 à ladite unité de traitement 16.

Cette unité de stockage 18 est susceptible d'enregistrer toutes les mesures réalisées par les capteurs C1 à C3, dans toute la bande de fréquences prescrite pour les ondes électromagnétiques OE à capter, de préférence sur un support autonome, par exemple une disquette, une bande magnétique ou une cartouche de mémoire, pouvant être séparé du dispositif 1 et dont les informations enregistrées peuvent être traitées ultérieurement par d'autres moyens non représentés.

Un tel enregistrement permet de tracer, pour chaque capteur C1 à C3, l'amplitude des mesures en fonction de la fréquence des ondes électromagnétiques captées, ce qui fournit une information essentielle pour déduire la durée de vie résiduelle des éléments protecteurs EP, dans le but d'une maintenance préventive.

Les informations enregistrées peuvent en effet être utilisées notamment pour prévoir les opérations de maintenance ultérieures, à partir de l'état d'usure réel constaté.

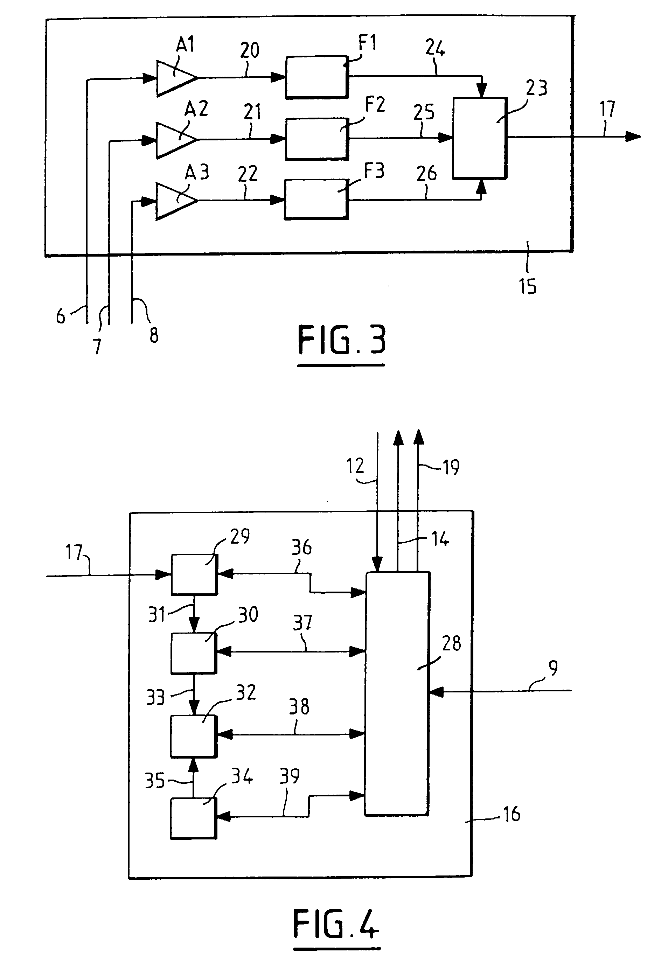

Ladite unité d'acquisition 15 comporte, tel que représenté sur la figure 3 :
- des préamplificateurs A1 à A3 reliés respectivement aux capteurs C1 à C3 ;
- des filtres passe-haut F1 à F3 reliés auxdits préamplificateurs A1 à A3 par l'intermédiaire de liaisons 20, 21 et 22 et destinés notamment à éliminer le bruit de fonctionnement du système S. La fréquence de coupure desdits filtres F1 à F3 est aussi élevée que possible, en fonction de la bande de fréquences prescrite des ondes électromagnétiques OE émises par ledit émetteur 2 ; et
- un commutateur 23 qui est relié auxdits filtres F1 à F3, respectivement par l'intermédiaire de liaisons 24 à 26, et qui permet de prendre en compte simultanément les mesures effectuées par tous les capteurs C1 à C3 prévus.

Par ailleurs, l'unité de traitement 16 comporte, quant à elle, tel que représenté sur la figure 4 :
- une unité de gestion 28 qui gère les différents traitements ;
- un système de démodulation 29 réalisant la démodulation des signaux reçus de l'unité d'acquisition 15 et ne conservant que la composante continue ;
- un convertisseur analogique/numérique 30 convertissant les signaux reçus dudit système 29 par une liaison 31 ; et
- une unité de calcul 32 qui réalise les comparaisons précitées entre les valeurs mesurées et reçues du convertisseur 30 par une liaison 33, et ladite valeur de référence reçue d'une mémoire 34 par une liaison 35, ladite valeur de référence pouvant être modifiée par l'unité de gestion 28 ou par d'autres moyens non représentés.

Ladite unité de gestion 28 est responsable de la synchronisation des différentes étapes d'acquisition, de calcul et de commande nécessaires à la mise en oeuvre de la présente invention.

A cet effet, cette unité de gestion 28 est notamment reliée par l'intermédiaire de liaisons 36 à 39 auxdits éléments 29, 30, 32 et 34.

On notera par ailleurs qu'en fonction de la technologie utilisée, on peut en particulier inverser les positions du commutateur 23 et du système de démodulation 29, dans l'architecture de l'unité centrale 5.

De plus, selon l'invention, lesdits capteurs C1 à C3 sont susceptibles d'être mis dans un état de veille constant, dans lequel ils captent et transmettent à l'unité centrale 5, qui les stocke dans la mémoire 18, toutes les valeurs mesurées qui sont supérieures à une valeur prédéterminée, ou pour lesquelles la durée d'émission est supérieure à une durée prédéterminée. Dans ce mode de réalisation particulier, on peut de plus prévoir un compteur d'événement non représenté qui est incrémenté lors de chaque détection d'un tel signal précité.

Lors de la mise à l'arrêt du système S, la présence de tels signaux stockés peut entraîner une opération de vérification pour savoir s'ils proviennent d'une défaillance de la protection électromagnétique ou simplement de l'exposition du système S à un environnement extrêmement défavorable, d'un point de vue électromagnétique, voire à un environnement plus sévère que celui pour lequel le système S a été conçu.

On notera de plus que, lorsque ledit système S comporte un calculateur non représenté de surveillance globale de l'état dudit système, ladite unité centrale 5 peut être directement intégrée dans ce calculateur.

Selon l'invention, on peut de plus prévoir, dans ladite unité centrale 5, des moyens permettant un déclenchement automatique de la mise en oeuvre de l'invention, par exemple de façon périodique et/ou à chaque mise à l'arrêt du système S.

## Revendications

1. Dispositif pour détecter et localiser d'éventuelles anomalies de la protection électromagnétique d'un système (S) comportant des corps électriques (CE) et des éléments protecteurs (EP) de ces corps électriques (CE), formant ladite protection électromagnétique, ledit dispositif comprenant au moins un émetteur (2) et un récepteur (C1, C2, C3) d'ondes électromagnétiques (OE), ainsi qu'une unité de traitement d'informations,
caractérisé en ce que :
- ledit émetteur (2) comporte une antenne (4) susceptible d'émettre une onde électromagnétique (OE) à l'extérieur dudit système (S) ;
- ledit récepteur comprend un ensemble de capteurs (C1, C2, C3) susceptibles de mesurer une grandeur représentative d'une onde électromagnétique (OE) captée, associés à au moins certains desdits éléments protecteurs (EP) et agencés de façon à être protégés par lesdits éléments protecteurs (EP) ; et
- ladite unité de traitement d'informations est une unité centrale (5) :
. recevant les valeurs de la grandeur mesurée par lesdits capteurs (C1, C2, C3), lors de l'émission d'une onde électromagnétique (OE) par ledit émetteur (2),
. comparant ces valeurs à une valeur de référence enregistrée et mesurée dans une étape préliminaire lors de l'émission d'une onde électromagnétique identique dans un état de référence de la protection électromagnétique,
. détectant, à partir de ces comparaisons, d'éventuelles anomalies de la protection électromagnétique, et
. localisant, le cas échéant, une anomalie en fonction de la position des capteurs, dont les valeurs mesurées sont incriminées.

2. Dispositif selon la revendication 1,
caractérisé en ce que ledit émetteur (2) fait partie dudit système (S).

3. Dispositif selon l'une des revendications 1 ou 2,
caractérisé en ce qu'il comporte une alarme (13) qui est déclenchée lorsqu'une anomalie est détectée.

4. Dispositif selon l'une quelconque des revendications précédentes,
caractérisé en ce que ladite unité centrale (5) comporte une unité de stockage (18) enregistrant les mesures réalisées par lesdits capteurs (C1, C2, C3).

5. Dispositif selon la revendication 4,
caractérisé en ce que ladite unité de stockage (18) effectue les enregistrements sur un support autonome, pouvant être séparé dudit dispositif (1).

6. Dispositif selon l'une quelconque des revendications 1 à 5,
caractérisé en ce que l'état de référence de la protection électromagnétique correspond à l'état neuf de ladite protection électromagnétique.

7. Dispositif selon l'une quelconque des revendications 1 à 5,
caractérisé en ce que l'état de référence de la protection électromagnétique correspond à l'état résultant d'une opération de maintenance.

8. Dispositif selon l'une quelconque des revendications précédentes,
caractérisé en ce que lesdits capteurs (C1, C2, C3) sont susceptibles d'être mis dans un état de veille constant, dans lequel ils captent et transmettent à l'unité centrale (5) toutes les valeurs mesurées qui sont supérieures à une valeur prédéterminée.

9. Dispositif selon l'une quelconque des revendications précédentes,
caractérisé en ce que lesdits capteurs (C1, C2, C3) sont susceptibles d'être mis dans un état de veille constant, dans lequel ils captent et transmettent à l'unité centrale (5) toutes les valeurs mesurées, pour lesquelles les ondes électromagnétiques correspondantes présentent des durées d'émission supérieures à une durée prédéterminée.

10. Dispositif selon l'une quelconque des revendications 1 à 9,
caractérisé en ce que lesdits capteurs (C1, C2, C3) sont reliés électriquement à l'unité centrale (5).

11. Dispositif selon l'une quelconque des revendications 1 à 9,
caractérisé en ce que lesdits capteurs (C1, C2, C3) sont reliés par l'intermédiaire de fibres optiques à l'unité centrale (5).

12. Dispositif selon l'une quelconque des revendications 1 à 11,
caractérisé en ce que ladite grandeur mesurée par les capteurs (C1, C2, C3) est une grandeur électrique.

13. Dispositif selon l'une quelconque des revendications 1 à 11,
caractérisé en ce que ladite grandeur mesurée par les capteurs (C1, C2, C3) est une grandeur radioélectrique.

14. Dispositif selon l'une quelconque des revendications 1 à 13,
caractérisé en ce que ledit émetteur (2) est un émetteur à modulation d'amplitude.

15. Dispositif selon l'une quelconque des revendications 1 à 13,
caractérisé en ce que ledit émetteur (2) est un émetteur à modulation de fréquence.

16. Dispositif selon l'une quelconque des revendications précédentes,
caractérisé en ce que ladite unité centrale (5) comporte des moyens pour modifier ladite valeur de référence enregistrée.

17. Dispositif selon l'une quelconque des revendications précédentes,
caractérisé en ce que ledit système (S) correspond au moins à une partie d'un aéronef.

## Patentansprüche

1. Anordnung zur Aufspürung und Lokalisierung eventueller Fehler der elektromagnetischen Abschirmung eines Systems (S), das elektrische Körper (CE) und Schutzelemente (EP) für diese elektrischen Körper (CE) umfasst, die die elektromagnetische Abschirmung bilden, wobei die Anordnung wenigstens einen Sender (2) und einen Empfänger (C1, C2, C3) für elektromagnetische Wellen (OE) sowie eine Informationsverarbeitungseinheit umfasst,
dadurch gekennzeichnet, dass:
- der Sender (2) eine Antenne (4)umfasst, die zur Aussendung einer elektromagnetischen Welle (OE) aus dem System (S) heraus ausgelegt ist;
- der Empfänger besteht aus einer Gruppe von Sensoren (C1, C2, C3), die zur Messung einer Größe ausgelegt sind, die für eine erfasste elektromagnetische Welle (OE) charakteristisch ist, und die mit wenigstens einigen der Schutzelemente (EP) verbunden und so angeordnet sind, dass sie von den Schutzelementen (EP) geschützt werden; und
- die Informationsverarbeitungseinheit eine Zentraleinheit (5) ist:
. die bei Aussendung einer elektromagnetischen Welle (OE) durch den Sender (2) die Werte der von den Sensoren (C1, C2, C3) gemessenen Größe empfängt,
. diese Werte mit einem Bezugswert vergleicht, der in einem vorherigen Schritt bei Aussendung einer gleichen elektromagnetischen Welle in einem Bezugszustand der elektromagnetischen Abschirmung aufgezeichnet und gemessen wurde,
. ausgehend von diesen Vergleichen eventuelle Fehler der elektromagnetischen Abschirmung aufspürt und
. gegebenenfalls einen Fehler in Abhängigkeit von der Position der Sensoren lokalisiert, deren Werte beanstandet werden.

2. Anordnung nach Anspruch 1, dadurch gekennzeichnet, dass der Sender (2) einen Teil des Systems (S) bildet.

3. Anordnung nach einem der Ansprüche 1 oder 2, dadurch gekennzeichnet, dass sie einen Alarm (13) umfasst, der ausgelöst wird, wenn ein Fehler aufgespürt wurde.

4. Anordnung nach einem der vorhergehenden Ansprüche, dadurch gekennzeichnet, dass die Zentraleinheit (5) eine Speichereinheit (18) umfasst, die die von den Sensoren (C1, C2, C3) ausgeführten Messungen aufzeichnet.

5. Anordnung nach Anspruch 4, dadurch gekennzeichnet, dass die Speichereinheit (18) die Aufzeichnungen auf einem eigenständigen Träger umfasst, der von der Anordnung (1) getrennt werden kann.

6. Anordnung nach einem der Ansprüche 1 bis 5, dadurch gekennzeichnet, dass der Bezugszustand der elektromagnetischen Abschirmung dem Neuzustand der elektromagnetischen Abschirmung entspricht.

7. Anordnung nach einem der Ansprüche 1 bis 5, dadurch gekennzeichnet, dass der Bezugszustand der elektromagnetischen Abschirmung dem Zustand entspricht, der sich aus einem Wartungsvorgang ergibt.

8. Anordnung nach einem der vorhergehenden Ansprüche, dadurch gekennzeichnet, dass die Sensoren (C1, C2, C3) dazu ausgelegt sind, in einen dauernden Bereitschaftszustand versetzt zu werden, in welchem sie alle gemessenen Werte, die größer als ein vorbestimmter Wert sind, erfassen und zur Zentraleinheit (5) übertragen.

9. Anordnung nach einem der vorhergehenden Ansprüche, dadurch gekennzeichnet, dass die Sensoren (C1, C2, C3) dazu ausgelegt sind, in einen dauernden Bereitschaftszustand versetzt zu werden, in welchem sie alle gemessenen Werte, für welche die entsprechenden elektromagnetischen Wellen Sendedauern aufweisen, die größer als eine vorbestimmte Dauer sind, erfassen und zur Zentraleinheit (5) übertragen.

10. Anordnung nach einem der Ansprüche 1 bis 9, dadurch gekennzeichnet, dass die Sensoren (C1, C2, C3) mit der Zentraleinheit (5) elektrisch verbunden sind.

11. Anordnung nach einem der Ansprüche 1 bis 9, dadurch gekennzeichnet, dass die Sensoren (C1, C2, C3) über optische Fasern mit der Zentraleinheit (5) verbunden sind.

12. Anordnung nach einem der Ansprüche 1 bis 11, dadurch gekennzeichnet, dass die von den Sensoren (C1, C2, C3) gemessene Größe eine elektrische Größe ist.

13. Anordnung nach einem der Ansprüche 1 bis 11, dadurch gekennzeichnet, dass die von den Sensoren (C1, C2, C3) gemessene Größe eine funktechnische Größe ist.

14. Anordnung nach einem der Ansprüche 1 bis 13, dadurch gekennzeichnet, dass der Sender (2) ein Sender mit Amplitudenmodulation ist.

15. Anordnung nach einem der Ansprüche 1 bis 13, dadurch gekennzeichnet, dass der Sender (2) ein Sender mit Frequenzmodulation ist.

16. Anordnung nach einem der vorhergehenden Ansprüche, dadurch gekennzeichnet, dass die Zentraleinheit (5) Mittel zum Verändern des aufgezeichneten Bezugswertes umfasst.

17. Anordnung nach einem der vorhergehenden Ansprüche, dadurch gekennzeichnet, dass das System (S) wenigstens einem Teil eines Luftfahrzeugs entspricht.

## Claims

1. A device for detecting and locating anomalies in the electromagnetic protection of a system (S) including electrical bodies (CE) and protective members (EP) for said electrical bodies (CE) and forming said electromagnetic protection, said device including at least a transmitter (2) and a receiver (C1, C2, C3) of electromagnetic waves (OE) and a data processing unit,
characterized in that:
- said transmitter (2) includes an antenna (4) adapted to transmit an electromagnetic wave (OE) externally of said system (S),
- said receiver includes a set of sensors (C1, C2, C3) associated with at least some of said protective members (EP) and adapted to be protected by said protective members (EP) and to measure a representative parameter of a received electromagnetic wave (OE), and
- said data processing unit is a central unit (5):
. receiving the values of the parameter measured by said sensors (C1, C2, C3) when an electromagnetic wave (OE) is transmitted by said transmitter (2),
. comparing these values with a prerecorded reference value measured in a preliminary step during the transmission of an identical electromagnetic wave in a reference state of the electromagnetic protection,
. on the basis of such comparison, detecting any electromagnetic protection anomalies, and
. if necessary, locating an anomaly in accordance with the location of the sensors the measured values from which are suspect.

2. The device according to claim 1,
characterized in that said transmitter (2) is part of said system (S).

3. A device according to claim 1 or claim 2,
characterized in that it includes an alarm (13) that is triggered if an anomaly is detected.

4. The device according to any one of the preceding claims,
characterized in that said central unit (5) includes a storage unit (18) recording the measurements carried out by said sensors (C1, C2, C3).

5. The device according to claim 4,
characterized in that said storage unit (18) records on a self-contained storage medium that can be removed from said device (1).

6. The device according to any one of claims 1 to 5,
characterized in that the reference state of the electromagnetic protection corresponds to the brand new state of said electromagnetic protection.

7. The device according to any one of claims 1 to 5,
characterized in that the reference state of the electromagnetic protection corresponds to the state resulting from a maintenance operation.

8. The device according to any one of the preceding claims,
characterized in that said sensors (C1, C2, C3) are adapted to be placed in a constant watching state in which they pick up and transmit to the central unit (5) all measured values which are greater than a predetermined value.

9. The device according to any one of the preceding claims,
characterized in that said sensors (C1, C2, C3) are adapted to be placed in a constant watching state in which they pick up and transmit to the central unit (5) all measured values for which the corresponding electromagnetic waves have transmission times greater than a predetermined time.

10. The device according to any one of claims 1 to 9,
characterized in that said sensors (C1, C2, C3) are electrically connected to the central unit (5).

11. The device according to any one of claims 1 to 9,
characterized in that said sensors (C1, C2, C3) are connected to the central unit (5) by optical fibers.

12. The device according to any one of claims 1 to 11,
characterized in that said parameter measured by the sensors (C1, C2, C3) is an electrical parameter.

13. The device according to any one of claims 1 to 11,
characterized in that said parameter measured by the sensors (C1, C2, C3) is a radio parameter.

14. The device according to any one of claims 1 to 13,
characterized in that said transmitter (2) is an amplitude modulation transmitter.

15. The device according to any one of claims 1 to 13,
characterized in that said transmitter (2) is a frequency modulation transmitter.

16. The device according to any one of the preceding claims,
characterized in that said central unit (5) includes means for modifying said prerecorded reference value.

17. The device according to any one of the preceding claims,
characterized in that said system (S) corresponds to at least part of an aircraft.
